# FASCICULE DE BREVET EUROPEEN

(11) **EP 3 059 597 B1**
(45) Date de publication et mention de la délivrance du brevet: **28.06.2017**
(21) Numéro de dépôt: 16155466.2
(22) Date de dépôt: 12.02.2016
(51) Int. Cl.: G01R 29/08, G01V 3/08

(54) **DISPOSITIF DE MESURE D'UN CHAMP ÉLECTRIQUE EN MILIEU CONDUCTEUR**
VORRICHTUNG ZUM MESSEN EINES ELEKTRISCHEN FELDS IN EINEM LEITERMILIEU
DEVICE FOR MEASURING AN ELECTRIC FIELD IN A CONDUCTIVE MEDIUM

(30) Priorité: 17.02.2015 FR 1551296
(43) Date de publication de la demande: 24.08.2016
(73) Titulaire: COMMISSARIAT À L'ÉNERGIE ATOMIQUE ET AUX ÉNERGIES ALTERNATIVES, 75015 Paris (FR)
(72) Inventeur: BAICRY, Mathieu, 38360 SASSENAGE (FR); BERTRAND, François, 38180 SEYSSINS (FR); LE PRADO, Matthieu, 38160 SAINT-MARCELLIN (FR); LEGER, Jean-Michel, 38190 VILLARD BONNOT (FR)
(74) Mandataire: Thibon, Laurent

(56) Documents cités:
- FR-A1- 2 690 750
- US-A- 3 641 427
- US-A1- 2009 001 986

## Description

### Domaine

La présente demande concerne un dispositif de mesure d'un champ électrique en milieu conducteur. Elle s'applique en particulier à des mesures de champ électrique sous-marines.

### Exposé de l'art antérieur

On a déjà proposé un dispositif de mesure d'un champ électrique en mer, ou électromètre marin, comportant deux électrodes immergées éloignées d'une distance 1, reliées à un dispositif de mesure de tension. Pour mesurer un champ électrique E dans la zone située entre les deux électrodes, on mesure la tension U entre les électrodes. Le champ E se déduit de cette mesure par la formule E = U/d. Les électromètres de ce type sont dits "à mesure de tension".

Un inconvénient des électromètres à mesure de tension est que seule une très faible partie du courant se propageant dans le milieu conducteur constitué par l'eau de mer est déviée dans le dispositif de mesure de tension, ce qui pose des problèmes de métrologie. De plus, les électromètres à mesure de tension sont généralement encombrants. En effet, pour obtenir un rapport signal sur bruit satisfaisant, la distance d séparant les deux électrodes doit être relativement importante, typiquement de l'ordre de quelques mètres à plusieurs kilomètres.

Pour pallier ces inconvénients, on a proposé un autre type de dispositif de mesure de champ électrique en milieu conducteur, dit "à mesure de courant", qui réalise une détermination de la densité de courant produit, sous l'effet du champ électrique, dans un volume fixé de milieu conducteur.

Un dispositif de ce type est par exemple décrit dans le brevet français N°9102273 de la demanderesse (déposé le 26 février 1991). Les dispositifs de ce type, que l'on appellera ci-après électromètres à mesure de courant, peuvent être plus compacts que les électromètres à mesure de tension, et peuvent en outre présenter une meilleure sensibilité.

Les documents US3641427 et US2009/001986 décrivent d'autres exemples d'électromètres à mesure de courant.

La présente demande vise plus particulièrement des électromètres à mesure de courant. Il existe en effet un besoin d'améliorer certains aspects des électromètres à mesure de courant existants.

### Résumé

Ainsi, un mode de réalisation prévoit un dispositif de mesure d'un champ électrique en milieu conducteur, comprenant : une enceinte isolante ; des première, deuxième et troisième paires d'électrodes, les électrodes d'une même paire étant disposées sur des parois extérieures opposées de l'enceinte, et les électrodes des première, deuxième et troisième paires étant centrées sur des premier, deuxième et troisième axes orthogonaux ; une première bobine conductrice ; une première paire de commutateurs permettant de connecter alternativement la première bobine entre les électrodes de la première, de la deuxième et de la troisième paire d'électrodes ; et un unique magnétomètre.

Selon un mode de réalisation, le dispositif comporte en outre : des deuxième et troisième bobines conductrices ; et des deuxième et troisième paires de commutateurs permettant respectivement de connecter alternativement la deuxième bobine entre les électrodes de la première, de la deuxième et de la troisième paire d'électrodes, et de connecter alternativement la troisième bobine entre les électrodes de la première, de la deuxième et de la troisième paire d'électrodes, dans lequel le magnétomètre est adapté à mesurer un champ magnétique induit par la circulation de courants dans les première, deuxième et troisième bobines.

Selon un mode de réalisation, les première, deuxième et troisième bobines sont connectées en série respectivement à des première, deuxième et troisième résistances variables.

Selon un mode de réalisation, le dispositif comporte un circuit de commande adapté à mettre en oeuvre successivement les étapes suivantes : commander les commutateurs de façon que les première, deuxième et troisième bobines ne soient pas reliées aux électrodes, et mesurer le module et la direction du champ magnétique ambiant ; et commander les résistances variables de façon que la circulation d'un courant dans l'association en parallèle d'une première branche comportant la première résistance variable et la première bobine, d'une deuxième branche comportant la deuxième résistance variable et la deuxième bobine, et d'une troisième branche comportant la troisième résistance variable et la troisième bobine, induise, au niveau du magnétomètre, un champ magnétique sensiblement parallèle au champ magnétique ambiant.

Selon un mode de réalisation, le circuit de commande est en outre adapté à mettre en oeuvre successivement les étapes suivantes : commander les commutateurs de façon que les première, deuxième et troisième branches soient connectées en parallèle entre les électrodes de la première paire d'électrodes et ne soient pas connectées aux deuxième et troisième paires d'électrodes, puis mesurer le module du champ magnétique au niveau du magnétomètre ; commander les commutateurs de façon que les première, deuxième et troisième branches soient connectées en parallèle entre les électrodes de la deuxième paire d'électrodes et ne soient pas connectées aux première et troisième paires d'électrodes, puis mesurer le module du champ magnétique au niveau du magnétomètre ; et commander les commutateurs de façon que les première, deuxième et troisième branches soient connectées en parallèle entre les électrodes de la troisième paire d'électrodes et ne soient pas connectées aux première et deuxième paires d'électrodes, puis mesurer le module du champ magnétique au niveau du magnétomètre.

Selon un mode de réalisation, les première, deuxième et troisième bobines ont des axes longitudinaux non parallèles, par exemple sensiblement orthogonaux.

Selon un mode de réalisation, le magnétomètre est un magnétomètre scalaire.

Selon un mode de réalisation, le dispositif comporte un circuit de commande adapté à mettre en oeuvre successivement les étapes suivantes : commander les commutateurs de façon que la première bobine ne soit pas connectée aux électrodes , et réaliser une mesure vectorielle du champ magnétique ambiant ; commander les commutateurs de façon que la première bobine soit connectée entre les électrodes de la première paire d'électrodes et ne soit pas connectée aux deuxième et troisième paires d'électrodes, puis réaliser une mesure vectorielle du champ magnétique au niveau du magnétomètre ; commander les commutateurs de façon que la première bobine soit connectée entre les électrodes de la deuxième paire d'électrodes et ne soit pas connectée aux première et troisième paires d'électrodes, puis réaliser une mesure vectorielle du champ magnétique au niveau du magnétomètre ; et commander les commutateurs de façon que la première bobine soit connectée entre les électrodes de la troisième paire d'électrodes et ne soit pas connectée aux première et deuxième paires d'électrodes, puis réaliser une mesure vectorielle du champ magnétique au niveau du magnétomètre.

Selon un mode de réalisation, le magnétomètre est un magnétomètre vectoriel.

Selon un mode de réalisation, les électrodes ont sensiblement la même surface, et une même distance sépare les deux électrodes de chacune des trois paires d'électrodes.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1 représente de façon schématique un électromètre à mesure de courant ;
la figure 2 représente de façon plus détaillée un exemple d'électromètre à mesure de courant décrit dans le brevet français N°9102273 susmentionné ;
les figures 3A et 3B sont des vues en coupe représentant de façon schématique un exemple d'un mode de réalisation d'un électromètre à mesure de courant ; et
les figures 4A et 4B sont des vues en coupe représentant de façon schématique un exemple d'un autre mode de réalisation d'un électromètre à mesure de courant.

### Description détaillée

De mêmes éléments ont été désignés par de mêmes références aux différentes figures et, de plus, les diverses figures ne sont pas tracées à l'échelle. En outre, seuls les éléments utiles à la compréhension des modes de réalisation décrits ont été détaillés. En particulier, les circuits de commande et/ou d'analyse et de traitement des électromètres décrits n'ont pas été détaillés, la réalisation de ces circuits étant à la portée de l'homme du métier ayant lu la présente description. En outre, dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures. Par ailleurs, dans la suite de la description, sauf précision contraire, les expressions "approximativement", "sensiblement", et "de l'ordre de" signifient à 10 % près, de préférence à 5 % près.

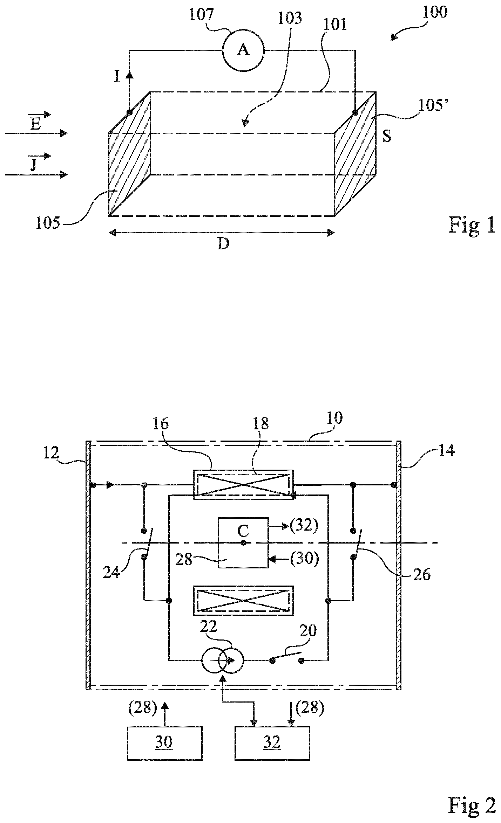

La figure 1 représente de façon schématique un exemple d'un électromètre à mesure de courant 100 destiné à être placé dans un milieu conducteur dans lequel on souhaite mesurer un champ électrique, par exemple de l'eau de mer. L'électromètre 100 comprend une enceinte 101 hermétiquement close, représentée en traits pointillés sur la figure, délimitant un volume 103 d'un milieu isolant, par exemple de l'air ou du vide. Deux électrodes 105 et 105' sont disposées à l'extérieur de l'enceinte 101, sur des faces opposées de l'enceinte, de façon que chaque électrode ait une face en contact avec le milieu conducteur lorsque l'électromètre est immergé. Dans cet exemple, les deux électrodes 105 et 105' sont approximativement planes et parallèles entre elles, ont sensiblement la même surface S, et sont séparées par une distance D. Un dispositif de mesure de courant 107 relie les deux électrodes.

En fonctionnement, l'électromètre 100 est immergé dans un milieu conducteur soumis à un champ électrique E que l'on souhaite mesurer. Sous l'effet du champ électrique E, un courant de densité J = α*σₑ*E circule dans le milieu conducteur, σₑ désignant la conductivité électrique du milieu conducteur, et α étant un coefficient fonction du rapport entre la conductivité électrique σ_{c} du capteur et la conductivité électrique σₑ de l'eau, avec σ_{c} = D/(S*Z_{c}), Z_{c} désignant l'impédance de l'électromètre, avec Z_{c} = Z_{elec} + Zᵢₙₜ, Z_{elec} étant l'impédance des électrodes de l'électromètre et Zᵢₙₜ étant l'impédance du ou des éléments connectés entre les électrodes, parmi lesquels on trouve au moins le dispositif de mesure de courant 107.

Les électrodes 105 et 105' permettent de canaliser la densité de courant J produite dans le milieu conducteur sous l'effet du champ E. Le courant canalisé I circulant entre les électrodes 105 et 105' est égal à I = S*J. Ce courant I peut être mesuré par le dispositif de mesure de courant 107.

La conductivité σₑ du milieu conducteur dans lequel est utilisé l'électromètre 100 est supposée connue, et, connaissant les caractéristiques de l'électromètre, le coefficient α peut être déterminé. Le champ électrique E peut alors se déduire de la mesure du courant I par la formule E = I/(S*α*σₑ). L'électromètre peut comporter des moyens de traitement, non représentés, adaptés à déterminer le champ électrique E à partir de la mesure du courant I.

La figure 2 représente de façon plus détaillée un exemple d'électromètre à mesure de courant décrit dans le brevet français N°9102273 susmentionné. Dans cet exemple, la mesure du courant canalisé par les électrodes est réalisée en mesurant le champ magnétique produit par une bobine dans laquelle circule le courant canalisé. Le dispositif de la figure 2 comprend deux électrodes 12 et 14 placées sur des faces opposées d'une enceinte isolante 10, et reliées à un dispositif de mesure intérieur à l'enceinte 10. Une première bobine 16 est reliée en série aux électrodes 12 et 14. Le dispositif de la figure 2 comprend en outre une seconde bobine 18 de même axe longitudinal et de même centre géométrique C que la bobine 16. Parcourues par un courant identique, les bobines 16 et 18 engendrent des champs magnétiques identiques mais de sens contraires. La bobine 18 est reliée par l'intermédiaire d'un interrupteur 20 à une source de courant 22 variable. Deux interrupteurs 24 et 26 permettent de connecter en parallèle les bobines 16 et 18. Un capteur magnétométrique 28 est disposé à l'intérieur des bobines 16, 18. Ce capteur est relié à des moyens de commande 30 qui fournissent entre autres les signaux d'excitation nécessaires au fonctionnement du capteur, et à des moyens 32 d'analyse et de traitement qui permettent de déterminer un champ électrique à partir de la mesure du champ magnétique.

Pour déterminer un champ électrique en milieu conducteur, l'enceinte isolante 10 est plongée dans le milieu conducteur et positionnée selon l'axe du champ que l'on désire mesurer. L'axe reliant les électrodes détermine la direction de la composante électrique de champ mesurée.

Dans un premier temps, l'interrupteur 20 est ouvert, et les interrupteurs 24 et 26 sont fermés. Les bobines 16 et 18 sont donc connectées en parallèle et le courant provenant des électrodes 12 et 14 est égal dans chacune d'elles. Les bobines étant identiques et parcourues par des courants identiques mais de sens inverse, les champs magnétiques produits par chacune d'elles sont identiques mais de sens contraire. Le capteur magnétométrique 28 n'effectue donc que la mesure du champ magnétique local qui est enregistré et mis en mémoire.

Dans une seconde étape, les interrupteurs 24 et 26 sont ouverts alors que l'interrupteur 20 est fermé. La bobine 16, parcourue par un courant provenant des électrodes 12 et 14, engendre un champ magnétique qui se superpose au champ magnétique local. Commandée par les moyens 32 d'analyse et de traitement, la source de courant 22 délivre un courant d'intensité telle que le champ magnétique produit par la bobine 18 annule le champ magnétique produit par la bobine 16 sous l'effet du courant canalisé par les électrodes. Lorsque le champ magnétique mesuré par le capteur 28 égale la valeur du champ magnétique local préalablement enregistrée, l'intensité du courant débité par la source de courant 22 est égale à l'intensité du courant traversant la bobine 16. Connaissant la valeur du courant traversant la bobine 16, on peut alors déterminer le champ électrique dans l'axe reliant les électrodes 12 et 14 du dispositif.

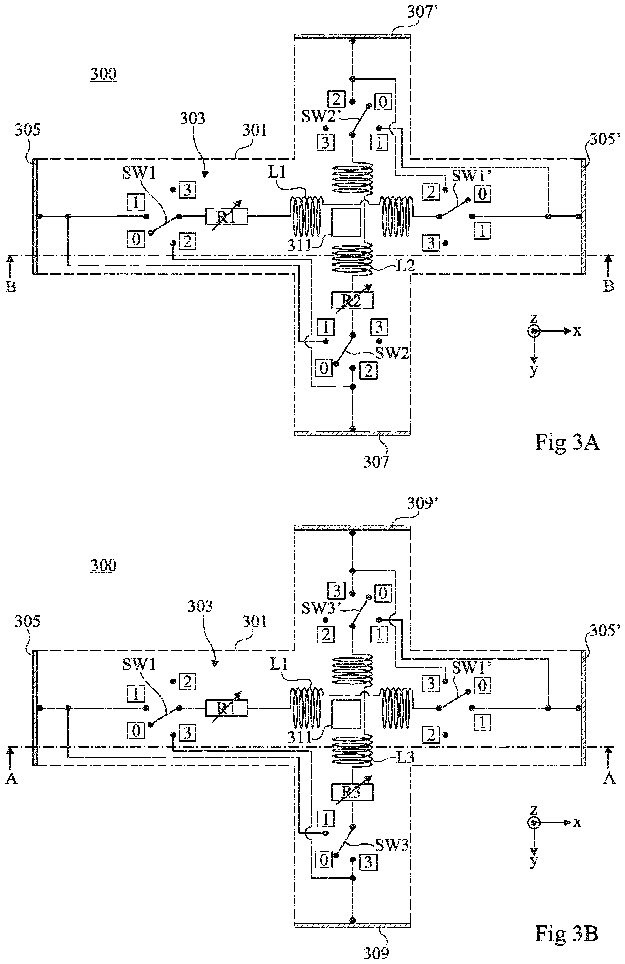

La figure 3 du brevet français N°9102273 susmentionné représente une variante du dispositif de mesure de champ électrique de la figure 2, permettant de déterminer deux composantes perpendiculaires du champ électrique. Toutefois, ce dispositif est relativement complexe. En effet, le dispositif de mesure intérieur à l'enceinte isolante 10 est réalisé en dupliquant l'architecture d'un dispositif de mesure monodirectionnel. Ainsi, un tel dispositif comprend au moins un magnétomètre par direction de mesure du champ électrique.

Un objet des modes de réalisation décrits est de prévoir un dispositif de mesure de champ électrique en milieu conducteur, ou électromètre, permettant de mesurer les trois composantes du champ électrique, ce dispositif présentant une architecture plus simple que les dispositifs connus adaptés à mesurer plusieurs composantes du champ électrique. En particulier, un objet des modes de réalisation décrits est de prévoir un dispositif ne comportant qu'un seul magnétomètre.

Les figures 3A et 3B représentent de façon schématique un exemple d'un mode de réalisation d'un électromètre à mesure de courant 300 destiné à être placé dans un milieu conducteur dans lequel on souhaite mesurer un champ électrique, par exemple de l'eau de mer. La figure 3A est une vue en coupe selon le plan A-A de la figure 3B, et la figure 3B est une vue en coupe selon le plan B-B de la figure 3A.

L'électromètre 300 comprend une enceinte 301 hermétiquement close, représentée en traits pointillés sur les figures, délimitant un volume 303 d'un milieu isolant, par exemple de l'air ou du vide. Trois paires d'électrodes 305, 305' ; 307, 307' ; et 309, 309' sont disposées sur des parois extérieures de l'enceinte, de façon que chaque électrode ait une face en contact avec le milieu conducteur. Les électrodes d'une même paire sont de préférence parallèles entre elles, et sont disposées sur des faces opposées de l'enceinte 301. Dans cet exemple, les électrodes 305, 305' de la première paire, les électrodes 307, 307' de la deuxième paire, et les électrodes 309, 309' de la troisième paire, sont centrées respectivement sur des premier, deuxième et troisième axes sensiblement orthogonaux passant par un même point situé sensiblement au centre de l'enceinte 301. L'enceinte 301 a par exemple la forme générale d'un assemblage de trois cylindres d'axes orthogonaux passant par un même point situé sensiblement au centre de chacun des cylindres. Les électrodes peuvent alors avoir la forme de disques placés sur les faces des cylindres, les électrodes d'une même paire étant disposées sur les deux faces opposées d'un même cylindre. Les modes de réalisation décrits ne se limitent toutefois pas à cette configuration particulière. A titre de variante, l'enceinte 301 peut avoir la forme générale d'un assemblage de trois portions de tube à section carrée d'axes orthogonaux passant par un même point situé sensiblement au centre de chacune des portions de tube. Les électrodes peuvent alors avoir la forme de plaques carrées placées sur les faces transversales des portions de tube. A titre de variante, l'enceinte 301 peut avoir la forme d'un cube, les six électrodes revêtant respectivement les six faces du cube. Les électrodes 305, 305', 307, 307', 309 et 309' ont par exemple sensiblement la même surface S. Une même distance D sépare par exemple les deux électrodes de chacune des trois paires d'électrodes.

Un dispositif de mesure situé à l'intérieur de l'enceinte 301 va maintenant être décrit. Le dispositif de mesure comprend une première branche comportant une bobine L1 en série avec une résistance variable R1, une deuxième branche comportant une bobine L2 en série avec une résistance variable R2, et une troisième branche comportant une bobine L3 en série avec une résistance variable R3. La première branche comprend, connecté à l'extrémité de la résistance R1 opposée à la bobine L1, un commutateur SW1 à quatre positions permettant de connecter la résistance R1 soit à l'électrode 305 (position 1), soit à l'électrode 307 (position 2), soit à l'électrode 309 (position 3), soit à aucune des électrodes de l'électromètre (position 0), et, connecté à l'extrémité de la bobine L1 opposée à la résistance R1, un commutateur SW1' à quatre positions permettant de connecter la bobine L1 soit à l'électrode 305' (position 1), soit à l'électrode 307' (position 2), soit à l'électrode 309' (position 3), soit à aucune des électrodes de l'électromètre (position 0). La deuxième branche comprend, connecté à l'extrémité de la résistance R2 opposée à la bobine L2, un commutateur SW2 à quatre positions permettant de connecter la résistance R2 soit à l'électrode 305 (position 1), soit à l'électrode 307 (position 2), soit à l'électrode 309 (position 3), soit à aucune des électrodes de l'électromètre (position 0), et, connecté à l'extrémité de la bobine L2 opposée à la résistance R2, un commutateur SW2' à quatre positions permettant de connecter la bobine L2 soit à l'électrode 305' (position 1), soit à l'électrode 307' (position 2), soit à l'électrode 309' (position 3), soit à aucune des électrodes de l'électromètre (position 0). La troisième branche comprend, connecté à l'extrémité de la résistance R3 opposée à la bobine L3, un commutateur SW3 à quatre positions permettant de connecter la résistance R3 soit à l'électrode 305 (position 1), soit à l'électrode 307 (position 2), soit à l'électrode 309 (position 3), soit à aucune des électrodes de l'électromètre (position 0), et, connecté à l'extrémité de la bobine L2 opposée à la résistance R2, un commutateur SW2' à quatre positions permettant de connecter la bobine L2 soit à l'électrode 305' (position 1), soit à l'électrode 307' (position 2), soit à l'électrode 309' (position 3), soit à aucune des électrodes de l'électromètre (position 0).

Les bobines L1, L2 et L3 ont des axes longitudinaux d'orientations distinctes. A titre d'exemple, les bobines L1, L2 et L3 ont des axes longitudinaux sensiblement orthogonaux, se croisant en un même point situé sensiblement au centre de l'enceinte 301. A titre d'exemple, chacune des bobines L1, L2 et L3 a pour axe longitudinal l'axe reliant en leurs centres les électrodes des première, deuxième et troisième paires d'électrodes respectivement.

L'électromètre 300 comprend en outre un unique magnétomètre 311 placé à l'intérieur de l'enceinte 301, adapté à mesurer le champ magnétique produit par la circulation d'un courant dans l'une quelconque des bobines L1, L2 et L3. A titre d'exemple, et comme cela est représenté sur les figures 3A et 3B, chacune des bobines L1, L2 et L3 est divisée en deux portions de bobines identiques de même axe reliées en série, disposées de part et d'autre d'une région centrale de l'enceinte 301. Le magnétomètre 311 peut alors être disposé dans la région centrale non occupée par les spires des bobines.

Dans cet exemple, le magnétomètre 311 est un magnétomètre scalaire absolu, c'est-à-dire un magnétomètre adapté à fournir une mesure absolue du module du champ magnétique. A titre d'exemple, le magnétomètre 311 est un magnétomètre à résonance magnétique nucléaire (RMN), ou, de préférence un magnétomètre à hélium 4 (basé sur la spectroscopie atomique de l'hélium 4) qui présente l'avantage par rapport aux magnétomètres RMN de fournir des mesures plus précises, y compris pour des champs très basse fréquence.

Le fonctionnement de l'électromètre 300 des figures 3A et 3B va maintenant être décrit.

Lors d'une première étape, les commutateurs SW1, SW1', SW2, SW2', SW3 et SW3' sont commandés en position 0 par un circuit de commande non représenté. Les électrodes 305, 305', 307, 307', 309 et 309' sont alors déconnectées du circuit de mesure, et les bobines L1, L2 et L3 ne sont traversées par aucun courant et ne produisent donc pas de champ magnétique. Le seul champ magnétique vu par le magnétomètre 311 est le champ magnétique ambiant. Le module B0 du champ magnétique ambiant est mesuré par le magnétomètre 311, et mémorisé par un circuit d'analyse et de traitement (non représenté) de l'électromètre. Lors de cette étape ou lors d'une étape préalable, l'orientation du champ magnétique ambiant est en outre déterminée. Une méthode de détermination de la direction d'un champ magnétique au moyen d'un magnétomètre à hélium 4 est par exemple décrite dans l'article intitulé "On the calibration of a vectorial 4He pumped magnetometer" de O. Gravant et al. (Earth Planets Space, 53, 949-958, 2001). A titre de variante, l'orientation du champ magnétique ambiant peut être déterminée au préalable par un dispositif de mesure extérieur à l'électromètre, et transmise au circuit d'analyse et de traitement de l'électromètre.

Lors d'une deuxième étape, les commutateurs SW1, SW1', SW2, SW2', SW3 et SW3' sont commandés en position 1. Les électrodes 307, 307', 309 et 309' sont alors déconnectées du circuit de mesure, et le courant Iₓ collecté par la paire d'électrodes 305, 305' est réparti dans les bobines L1, L2 et L3 selon une distribution qui dépend des valeurs des résistances R1, R2 et R3. Les valeurs des résistances R1, R2 et R3 sont réglées par un circuit de commande de façon que le champ magnétique global Bₓ produit par l'association en parallèle des bobines L1, L2 et L3 soit sensiblement colinéaire au champ magnétique ambiant. Le module B1 du champ magnétique vu par le magnétomètre 311, qui correspond à la somme du champ magnétique ambiant B0 et du champ magnétique Bₓ produit par les bobines sous l'effet du courant Iₓ, est alors mesuré par le magnétomètre 311. Le circuit d'analyse et de traitement peut en déduire le module du champ magnétique Bₓ, selon la formule Bₓ = B1-B0. Connaissant le taux de transfert électrique/magnétique de chacune des bobines L1, L2 et L3, on peut en déduire le courant Iₓ. Le courant Iₓ correspond au courant induit par la composante Eₓ du champ électrique selon un axe x orthogonal aux électrodes 305 et 305'. Ainsi, de façon similaire à ce qui a été expliqué ci-avant en relation avec la figure 1, on peut déduire du courant Iₓ la composante Eₓ du champ électrique selon la formule Eₓ = Iₓ/(S*α*σₑ).

Lors d'une troisième étape, les commutateurs SW1, SW1', SW2, SW2', SW3 et SW3' sont commandés en position 2. Les électrodes 305, 305', 309 et 309' sont alors déconnectées du circuit de mesure, et le courant I_{y} collecté par la paire d'électrodes 307, 307' est réparti dans les bobines L1, L2 et L3. Comme pour l'étape précédente, les valeurs des résistances R1, R2 et R3 sont réglées de façon que le champ magnétique global By produit par l'association en parallèle des bobines L1, L2 et L3 sous l'effet du courant I_{y} soit sensiblement colinéaire au champ magnétique ambiant. Le module B2 du champ magnétique vu par le magnétomètre 311 est alors mesuré par le magnétomètre 311. Le circuit d'analyse et de traitement peut en déduire le module du champ magnétique By selon la formule By = B2-B0, et, de façon similaire a ce qui a été décrit pour la deuxième étape, la composante Ey du champ électrique selon un axe y orthogonal aux électrodes 307 et 307'.

Lors d'une quatrième étape, les commutateurs SW1, SW1', SW2, SW2', SW3 et SW3' sont commandés en position 3. Les électrodes 305, 305', 307 et 307' sont alors déconnectées du circuit de mesure, et le courant I_{z} collecté par la paire d'électrodes 309, 309' est réparti dans les bobines L1, L2 et L3. Comme pour l'étape précédente, les valeurs des résistances R1, R2 et R3 sont réglées de façon que le champ magnétique global B_{z} produit par l'association en parallèle des bobines L1, L2 et L3 sous l'effet du courant I_{z} soit sensiblement colinéaire au champ magnétique ambiant. Le module B3 du champ magnétique vu par le magnétomètre 311 est alors mesuré par le magnétomètre 311. Le circuit d'analyse et de traitement peut en déduire le module du champ magnétique B_{z} selon la formule B_{z} = B3-B0, et, de façon similaire à ce qui a été décrit pour la deuxième étape, la composante E_{z} du champ électrique selon un axe z orthogonal aux électrodes 309 et 309'.

Ainsi, les étapes susmentionnées permettent de déterminer les trois composantes Eₓ, Ey et E_{z} du champ électrique dans le milieu conducteur dans lequel est plongé l'électromètre 300.

De préférence, les quatre étapes susmentionnées sont répétées périodiquement (à l'exception de la phase de détermination de la direction du champ magnétique ambiant qui peut être réalisée une seule fois), à une fréquence d'échantillonnage (fréquence de commutation des commutateurs SW1, SW1', SW2, SW2', SW3 et SW3') au moins deux fois supérieure à la fréquence maximale du champ électrique que l'on souhaite mesurer (critère de Nyquist-Shannon), par exemple à une fréquence d'échantillonnage comprise entre 1 et 1000 Hz. On notera que l'impédance 2_{elec} des électrodes, utilisée pour le calcul de la conductivité électrique σ_{c} du capteur, est alors l'impédance à la fréquence d'échantillonnage du dispositif, qui peut être plus faible que l'impédance en régime continu.

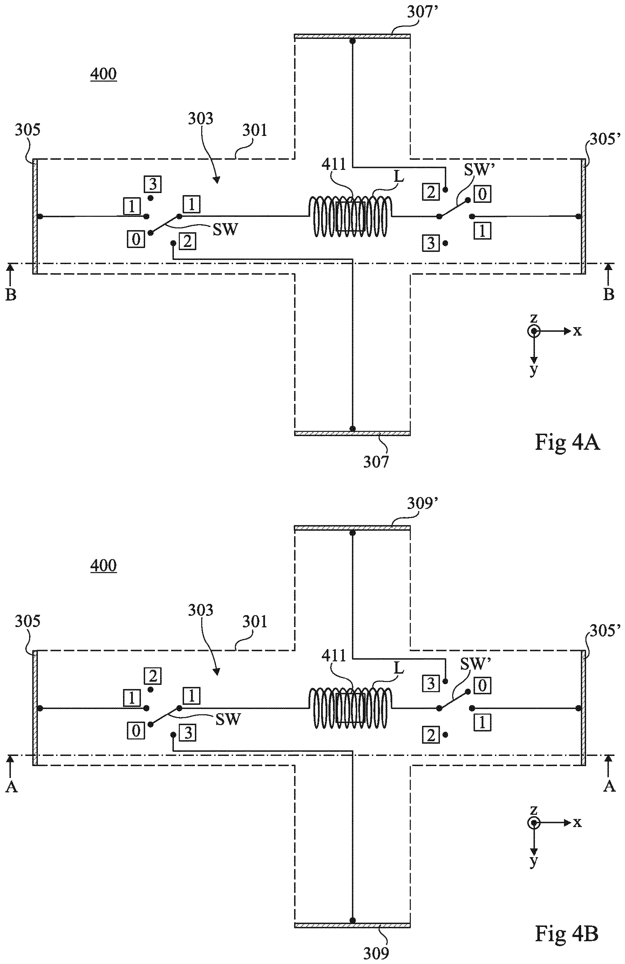

Les figures 4A et 4B représentent de façon schématique un exemple d'un autre mode de réalisation d'un électromètre à mesure de courant 400. La figure 4A est une vue en coupe selon le plan A-A de la figure 4B, et la figure 4B est une vue en coupe selon le plan B-B de la figure 4A.

L'électromètre 400 des figures 4A et 4B comprend des éléments communs avec l'électromètre 300 des figures 3A et 3B. Ces éléments ne seront pas décrits à nouveau. Dans la suite, seules les différences entres les électromètres 300 et 400 seront détaillées.

L'électromètre 400 diffère de l'électromètre 300 essentiellement par son dispositif de mesure intérieur à l'enceinte isolante 301.

Le dispositif de mesure de l'électromètre 400 comprend une unique bobine L. Il comprend en outre, connecté à une première extrémité de la bobine L, un commutateur SW à quatre positions permettant de connecter la première extrémité de la bobine soit à l'électrode 305 (position 1), soit à l'électrode 307 (position 2), soit à l'électrode 309 (position 3), soit à aucune des électrodes de l'électromètre (position 0), et, connecté à une deuxième extrémité de la bobine L opposée à la première extrémité, un commutateur SW' à quatre positions permettant de connecter la deuxième extrémité de la bobine soit à l'électrode 305' (position 1), soit à l'électrode 307' (position 2), soit à l'électrode 309' (position 3), soit à aucune des électrodes de l'électromètre (position 0).

L'électromètre 400 comprend en outre un unique magnétomètre 411 placé à l'intérieur de l'enceinte 301, adapté à mesurer le champ magnétique produit par la circulation d'un courant dans la bobine L. Dans l'exemple représenté, le magnétomètre 411 est placé à l'intérieur de la bobine L, sensiblement en son centre.

Le magnétomètre 411 est un magnétomètre vectoriel, c'est-à-dire un magnétomètre adapté à fournir une mesure des trois composantes du champ magnétique. A titre d'exemple, le magnétomètre 411 est un magnétomètre vectoriel à hélium 4 du type décrit dans l'article susmentionné de O. Gravant et al. A titre de variante, le magnétomètre 411 est un magnétomètre fluxgate, ou un magnétomètre à induction. On notera qu'un tel magnétomètre ne fournit pas nécessairement une mesure absolue des trois composantes du champ magnétique, mais fournit a minima une mesure relative.

Le fonctionnement de l'électromètre 400 des figures 4A et 4B va maintenant être décrit.

Lors d'une première étape, les commutateurs SW et SW' sont commandés en position 0 par un circuit de commande non représenté. Les électrodes 305, 305', 307, 307', 309 et 309' sont alors déconnectées du circuit de mesure, et la bobine L n'est traversée par aucun courant et ne produit donc pas de champ magnétique. Le champ magnétique ambiant B0 est alors mesuré de manière vectorielle par le magnétomètre 411, et mémorisé par un circuit d'analyse et de traitement (non représenté) de l'électromètre.

Lors d'une deuxième étape, les commutateurs SW et SW' sont commandés en position 1. Les électrodes 307, 307', 309 et 309' sont alors déconnectées du circuit de mesure, et le courant Iₓ collecté par la paire d'électrodes 305, 305' circule dans la bobine L, induisant un champ magnétique Bₓ parallèle à l'axe de la bobine L. Un champ magnétique B1, correspondant à la somme du champ magnétique Bₓ et du champ ambiant B0, est alors mesuré de manière vectorielle par le magnétomètre 411. Par soustraction vectorielle (composante par composante), on peut en déduire une valeur absolue du champ Bₓ. Comme dans l'exemple des figures 3A et 3B, on peut déduire de cette mesure le courant Iₓ, et la composante Eₓ du champ électrique selon la formule Eₓ = Iₓ/(S*α*σₑ).

Lors d'une troisième étape, les commutateurs SW et SW' sont commandés en position 2. Les électrodes 305, 305', 309 et 309' sont alors déconnectées du circuit de mesure, et le courant I_{y} collecté par la paire d'électrodes 307, 307' circule dans la bobine L, induisant un champ magnétique By parallèle à l'axe de la bobine L. Un champ magnétique B2, correspondant à la somme du champ magnétique By et du champ ambiant B0, est alors mesuré de manière vectorielle par le magnétomètre 411. De façon similaire à ce qui a été décrit pour la deuxième étape, le circuit d'analyse et de traitement peut en déduire le module du champ magnétique By, l'intensité du courant I_{y}, et la valeur de la composante Ey du champ électrique.

Lors d'une troisième étape, les commutateurs SW et SW' sont commandés en position 3. Les électrodes 305, 305', 307 et 307' sont alors déconnectées du circuit de mesure, et le courant I_{z} collecté par la paire d'électrodes 309, 309' circule dans la bobine L, induisant un champ magnétique B_{z} parallèle à l'axe de la bobine L. Un champ magnétique B3, correspondant à la somme du champ magnétique B_{z} et du champ ambiant B0, est alors mesuré de manière vectorielle par le magnétomètre 411. De façon similaire à ce qui a été décrit pour la deuxième étape, le circuit d'analyse et de traitement peut en déduire le module du champ magnétique B_{z}, l'intensité du courant I_{z}, et la valeur de la composante E_{z} du champ électrique.

Ainsi, les étapes susmentionnées permettent de déterminer les trois composantes Eₓ, Ey et E_{z} du champ électrique dans le milieu conducteur dans lequel est plongé l'électromètre 400.

De préférence, les quatre étapes susmentionnées sont répétées périodiquement à une fréquence d'échantillonnage (fréquence de commutation des commutateurs SW, SW') au moins deux fois supérieure à la fréquence maximale du champ électrique que l'on souhaite mesurer (critère de Nyquist-Shannon). A titre d'exemple, la fréquence d'échantillonnage est comprise entre 1 et 1000 Hz. L'impédance Z_{elec} des électrodes, utilisée pour le calcul de la conductivité électrique σ_{c} du capteur, est alors l'impédance à la fréquence d'échantillonnage du dispositif, qui peut être plus faible que l'impédance en régime continu.

Un avantage des modes de réalisation décrits est qu'ils permettent de fournir une mesure vectorielle (3D) du champ électrique, tout en présentant une architecture relativement simple, et en particulier ne comportant qu'un unique magnétomètre.

Le mode de réalisation des figures 3A et 3B présente l'avantage supplémentaire de fournir une mesure absolue du champ magnétique ambiant.

L'architecture du mode de réalisation des figures 4A et 4B est plus simple que celle du mode de réalisation des figures 3A et 3B, puisqu'elle ne comprend qu'une seule bobine (contre trois dans le mode de réalisation des figures 3A et 3B), et ne comprend pas les résistances variables R1, R2 et R3.

On notera que les magnétomètres vectoriels présentent généralement un bruit en 1/f, qui peut être gênant pour réaliser des mesures de champ électrique dans des bandes de fréquences faibles. L'architecture des figures 4A et 4B permet de s'affranchir de cet inconvénient, dans la mesure où la fréquence de commutation des interrupteurs SW, SW' peut être choisie suffisamment élevée (par exemple supérieure à 200 Hz) pour ramener le bruit en 1/f à un niveau acceptable.

L'architecture des figures 3A et 3B présente par ailleurs l'avantage d'être moins sensible aux défauts d'alignement que l'architecture des figures 4A et 4B. En effet, dans le mode de réalisation des figures 4A et 4B, il convient de veiller à ce que l'orientation du magnétomètre par rapport au champ terrestre reste stable pendant toute la durée de la mesure. En outre, l'alignement du magnétomètre 411 par rapport à la bobine L doit rester stable pendant la mesure.

## Revendications

1. Dispositif (300 ; 400) de mesure d'un champ électrique en milieu conducteur, comprenant :
une enceinte isolante (301) ;
des première (305, 305'), deuxième (307, 307') et troisième (309, 309') paires d'électrodes, les électrodes d'une même paire étant disposées sur des parois extérieures opposées de l'enceinte (301), et les électrodes des première, deuxième et troisième paires étant centrées sur des premier, deuxième et troisième axes orthogonaux ;
une première bobine conductrice (L1 ; L) ;
une première paire de commutateurs (SW1, SW1' ; SW, SW') permettant de connecter alternativement la première bobine entre les électrodes de la première (305, 305'), de la deuxième (307, 307') et de la troisième (309, 309') paire d'électrodes ; et
un unique magnétomètre (311 ; 411).

2. Dispositif (300) selon la revendication 1, comportant en outre :
des deuxième (L2) et troisième (L3) bobines conductrices ; et
des deuxième (SW2, SW2') et troisième (SW3, SW3') paires de commutateurs permettant respectivement de connecter alternativement la deuxième bobine (L2) entre les électrodes de la première (305, 305'), de la deuxième (307, 307') et de la troisième (309, 309') paire d'électrodes, et de connecter alternativement la troisième bobine (L3) entre les électrodes de la première (305, 305'), de la deuxième (307, 307') et de la troisième (309, 309') paire d'électrodes,
dans lequel le magnétomètre (311) est adapté à mesurer un champ magnétique induit par la circulation de courants dans les première (L1), deuxième (L2) et troisième (L3) bobines.

3. Dispositif (300) selon la revendication 2, dans lequel les première (L1), deuxième (L2) et troisième (L3) bobines sont connectées en série respectivement à des première (R1), deuxième (R2) et troisième (R3) résistances variables.

4. Dispositif (300) selon la revendication 3, comportant un circuit de commande adapté à mettre en oeuvre successivement les étapes suivante :
commander les commutateurs (SW1, SW1', SW2, SW2', SW3, SW3') de façon que les première (L1), deuxième (L2) et troisième (L3) bobines (L1, L2, L3) ne soient pas reliées aux électrodes (305, 305', 307, 307', 309, 309'), et mesurer le module et la direction du champ magnétique ambiant (B0) ; et
commander les résistances variables (R1, R2, R3) de façon que la circulation d'un courant dans l'association en parallèle d'une première branche comportant la première résistance variable (R1) et la première bobine (L1), d'une deuxième branche comportant la deuxième résistance variable (R2) et la deuxième bobine (L2), et d'une troisième branche comportant la troisième résistance variable (R3) et la troisième bobine (L3), induise, au niveau du magnétomètre (311), un champ magnétique sensiblement parallèle au champ magnétique ambiant (B0).

5. Dispositif (300) selon la revendication 4, dans lequel le circuit de commande est en outre adapté à mettre en oeuvre successivement les étapes suivantes :
commander les commutateurs (SW1, SW1', SW2, SW2', SW3, SW3') de façon que les première, deuxième et troisième branches soient connectées en parallèle entre les électrodes (305, 305') de la première paire d'électrodes et ne soient pas connectées aux deuxième (307, 307') et troisième (309, 309') paires d'électrodes, puis mesurer le module du champ magnétique (B1) au niveau du magnétomètre (311) ;
commander les commutateurs (SW1, SW1', SW2, SW2', SW3, SW3') de façon que les première, deuxième et troisième branches soient connectées en parallèle entre les électrodes (307, 307') de la deuxième paire d'électrodes et ne soient pas connectées aux première (305, 305') et troisième (309, 309') paires d'électrodes, puis mesurer le module du champ magnétique (B2) au niveau du magnétomètre (311) ; et
commander les commutateurs (SW1, SW1', SW2, SW2', SW3, SW3') de façon que les première, deuxième et troisième branches soient connectées en parallèle entre les électrodes (309, 309') de la troisième paire d'électrodes et ne soient pas connectées aux première (305, 305') et deuxième (307, 307') paires d'électrodes, puis mesurer le module du champ magnétique (B3) au niveau du magnétomètre (311).

6. Dispositif (300) selon l'une quelconque des revendications 2 à 5, dans lequel les première (L1), deuxième (L2) et troisième (L3) bobines ont des axes longitudinaux non parallèles, par exemple sensiblement orthogonaux.

7. Dispositif (300) selon l'une quelconque des revendications 2 à 6, dans lequel le magnétomètre (311) est un magnétomètre scalaire.

8. Dispositif (400) selon la revendication 1, comportant un circuit de commande adapté à mettre en oeuvre successivement les étapes suivante :
commander les commutateurs (SW, SW') de façon que la première bobine (L) ne soit pas connectée aux électrodes (305, 305', 307, 307', 309, 309'), et réaliser une mesure vectorielle du champ magnétique ambiant (B0) ;
commander les commutateurs (SW, SW') de façon que la première bobine (L) soit connectée entre les électrodes (305, 305') de la première paire d'électrodes et ne soit pas connectée aux deuxième (307, 307') et troisième (309, 309') paires d'électrodes, puis réaliser une mesure vectorielle du champ magnétique (B1) au niveau du magnétomètre (411) ;
commander les commutateurs (SW, SW') de façon que la première bobine (L) soit connectée entre les électrodes (307, 307') de la deuxième paire d'électrodes et ne soit pas connectée aux première (305, 305') et troisième (309, 309') paires d'électrodes, puis réaliser une mesure vectorielle du champ magnétique (B2) au niveau du magnétomètre (411) ; et
commander les commutateurs (SW, SW') de façon que la première bobine (L) soit connectée entre les électrodes (309, 309') de la troisième paire d'électrodes et ne soit pas connectée aux première (305, 305') et deuxième (307, 307') paires d'électrodes, puis réaliser une mesure vectorielle du champ magnétique (B3) au niveau du magnétomètre (411).

9. Dispositif (400) selon la revendication 1 ou 8, dans lequel le magnétomètre (411) est un magnétomètre vectoriel.

10. Dispositif (300 ; 400) selon l'une quelconque des revendications 1 à 9, dans lequel les électrodes (305, 305', 307, 307', 309, 309') ont sensiblement la même surface (S), et dans lequel une même distance (D) sépare les deux électrodes de chacune des trois paires d'électrodes.

## Patentansprüche

1. Eine Einrichtung (300; 400) zum Messen eines elektrischen Feldes in einem leitfähigen Medium, wobei die Einrichtung folgendes aufweist:
einen isolierenden Einschluss (301);
erste (305, 305'), zweite (307, 307') und dritte (309, 309') Elektrodenpaare, wobei die Elektroden eines gleichen Paars gegenüber von externen Wänden des Einschlusses (301) angeordnet sind, und wobei die Elektroden der ersten, zweiten und dritten Paare auf ersten, zweiten und dritten rechtwinkligen Achsen zentriert sind;
eine erste leitfähige Spule (L1; L);
ein erstes Paar von Schaltern (SW1, SW1', SW, SW'), zum Ermöglichen von alternativen Verbinden der ersten Spule zwischen den Elektroden des ersten (305, 305'), des zweiten (307, 307') und des dritten (309,309') Elektrodenpaars; und
ein einzelnes Magnetometer (311; 411).

2. Einrichtung (300) nach Anspruch 1, die ferner folgendes aufweist:
zweite (L2) und dritte (L3) leitende Spulen; und
zweite (SW2, SW2') und dritte (SW3, SW3') Schalterpaare zum entsprechenden Ermöglichen von alternativen Verbinden der zweiten Spule (L2) zwischen den Elektroden des ersten (305, 305'), des zweiten (307, 307') und des dritten (309, 309') Elektrodenpaars, und zum alternativen Verbinden der dritten Spule (L3) zwischen den Elektroden des ersten (305, 305'), des zweiten (307, 307') und des dritten (309, 309') Elektrodenpaars,
wobei das Magnetometer (311) in der Lage ist, ein magnetisches Feld zu messen, das durch Stromflüsse in den ersten (L1), zweiten (L2) und dritten (L3) Spulen induziert wird.

3. Einrichtung (300) nach Anspruch 2, wobei die ersten (L1), zweiten (L2), und dritten (L3) Spulen entsprechend zu ersten (R1), zweiten (R2), und dritten (R3) variablen Widerständen reihengeschaltet sind.

4. Einrichtung (300) nach Anspruch 3, die einen Steuerschaltkreis aufweist, der in der Lage ist, die folgenden Schritte nacheinander umzusetzen:
Steuern der Schalter (SW1, SW1', SW2, SW2', SW3, SW3') so, dass die ersten (L1), zweiten (L2) und dritten (L3) Spulen (L1, L2, L3) nicht mit den Elektroden (305, 305', 307, 307', 309, 309') verbunden sind, und Messen des Betrags und der Richtung des Umgebungsmagnetfelds (B0), und
Steuern der variablen Widerstände (R1, R2, R3) so, dass das Fließen eines Stromes in dem parallelen Zusammenschluss eines ersten Zweiges, der den ersten variablen Widerstand (R1) und die erste Spule (L1), eines zweiten Zweiges, der den zweiten variablen Widerstand (R2) und die zweite Spule (L2), und eines dritten Zweiges, der den dritten variable Widerstand (R3) und die dritte Spule (L3) aufweist, ein magnetisches Feld auf dem Niveau des Magnetometer (311) induziert, das weitestgehend parallel zu dem Umgebungsmagnetfeld (B0) ist.

5. Einrichtung (300) nach Anspruch 4, wobei der Steuerschaltkreis ferner in der Lage ist, die folgenden Schritte nacheinander umzusetzen:
Steuern der Schalter (SW1, SW1', SW2, SW2', SW3, SW3') so, dass die ersten, zweiten und dritten Zweige zwischen den Elektroden (305, 305') des ersten Elektrodenpaars parallel verbunden sind und nicht mit den zweiten (307, 307') und dritten (309, 309') Elektrodenpaaren verbunden sind, und dann Messen des Betrags des Magnetfelds (B1) auf dem Niveau des Magnetometers (311);
Steuern der Schalter (SW1, SW1', SW2, SW2', SW3, SW3') so, dass die ersten, zweiten und dritten Zweige zwischen den Elektroden (307, 307') des zweiten Elektrodenpaars parallel verbunden sind und nicht mit den ersten (305, 305') und dritten (309, 309') Elektrodenpaaren verbunden sind, und dann Messen des Betrags des Magnetfelds (B2) auf dem Niveau des Magnetometers (311);
Steuern der Schalter (SW1, SW1', SW2, SW2', SW3, SW3') so, dass die ersten, zweiten und dritten Zweige zwischen den Elektroden (309, 309') des dritten Elektrodenpaars parallel verbunden sind und nicht mit dem ersten (305, 305') und zweiten (307, 307') Elektrodenpaaren verbunden sind, und dann Messen des Betrags des Magnetfelds (B3) auf dem Niveau des Magnetometers (311).

6. Einrichtung (300) nach einem der Ansprüche 2 bis 5, wobei die ersten (L1), zweiten (L2) und dritten (L3) Spulen nichtparallele, z.B. im Wesentlichen rechtwinklige, Längsachsen haben.

7. Einrichtung (300) nach einem der Ansprüche 2 bis 6, wobei das Magnetometer (311) ein Skalarmagnetometer ist.

8. Einrichtung (400) nach Anspruch 1, die einen Steuerschaltkreis aufweist, der in der Lage ist, die folgenden Schritte nacheinander Umsetzen:
Steuern der Schalter (SW, SW') so, dass die erste Spule (L) nicht mit den Elektroden (305, 305', 307, 307', 309, 309') verbunden ist, und Durchführen einer Vektormessung des Umgebungsmagnetfelds (B0);
Steuern der Schalter (SW, SW') so, dass die erste Spule (L) zwischen den Elektroden (305, 305') des ersten Elektrodenpaars verbunden ist und nicht mit den zweiten (307, 307') und dritten (309, 309') Elektrodenpaaren verbunden ist, und dann Durchführen einer Vektormessung des Magnetfelds (B1) auf dem Niveau des Magnetometers (411);
Steuern der Schalter (SW, SW') so, dass die erste Spule (L) zwischen den Elektroden (307, 307') des zweiten Elektrodenpaars verbunden ist und nicht mit den ersten (305, 305') und dritten (309, 309') Elektrodenpaaren verbunden ist, und dann Durchführen einer Vektormessung des Magnetfelds (B2) auf dem Niveau des Magnetometers (411);
Steuern der Schalter (SW, SW') so, dass die erste Spule (L) zwischen den Elektroden (309, 309') des dritten Elektrodenpaars verbunden ist und nicht mit den ersten (305, 305') und zweiten (307, 307') Elektrodenpaaren verbunden ist, und dann Durchführen einer Vektormessung des Magnetfelds (B3) auf dem Niveau des Magnetometers (411).

9. Einrichtung (400) nach Anspruch 1 oder 8, wobei das Magnetometer (411) ein Vektormagnetometer ist.

10. Einrichtung (300; 400) nach einem der Ansprüche 1 bis 9, wobei die Elektroden (305, 305', 307, 307', 309, 309') im Wesentlichen die gleiche Oberflächenfläche (S) haben und wobei ein gleicher Abstand (D) die zwei Elektroden jedes der drei Elektrodenpaare trennt.

## Claims

1. A device (300; 400) for measuring an electric field in a conducting medium, comprising:
an insulating enclosure (301);
first (305, 305'), second (307, 307'), and third (309, 309') pairs of electrodes, the electrodes of a same pair being arranged on opposite external walls of the enclosure (301), and the electrodes of the first, second, and third pairs being centered on first, second, and third orthogonal axes;
a first conductive coil (L1; L);
a first pair of switches (SW1, SW1'; SW, SW') enabling to alternately connect the first coil between the electrodes of the first (305, 305'), of the second (307, 307'), and of the third (309, 309') pair of electrodes; and
a single magnetometer (311; 411).

2. The device (300) of claim 1, further comprising:
second (L2) and third (L3) conductive coils; and
second (SW2, SW2') and third (SW3, SW3') pairs of switches respectively enabling to alternately connect the second coil (L2) between the electrodes of the first (305, 305'), of the second (307, 307'), and of the third (309, 309') pair of electrodes, and to alternately connect the third coil (L3) between the electrodes of the first (305, 305'), of the second (307, 307'), and of the third (309, 309') pair of electrodes,
wherein the magnetometer (311) is capable of measuring a magnetic field induced by the flowing of currents in the first (L1), second (L2), and third (L3) coils.

3. The device (300) of claim 2, wherein the first (L1), second (L2), and third (L3) coils are series-connected respectively to first (R1), second (R2), and third (R3) variable resistors.

4. The device (300) of claim 3, comprising a control circuit capable of successively implementing the steps of:
controlling the switches (SW1, SW1', SW2, SW2', SW3, SW3') so that the first (L1), second (L2), and third (L3) coils (L1, L2, L3) are not connected to the electrodes (305, 305', 307, 307', 309, 309'), and measuring the module and the direction of the ambient magnetic field (B0); and
controlling the variable resistors (R1, R2, R3) so that the flowing of a current in the parallel association of a first branch comprising the first variable resistor (R1) and the first coil (L1), of a second branch comprising the second variable resistor (R2) and the second coil (L2), and of a third branch comprising the third variable resistor (R3) and the third coil (L3), induces, at the level of the magnetometer (311), a magnetic field substantially parallel to the ambient magnetic field (B0).

5. The device (300) of claim 4, wherein the control circuit is further capable of successively implementing the steps of:
controlling the switches (SW1, SW1', SW2, SW2', SW3, SW3') so that the first, second, and third branches are connected in parallel between the electrodes (305, 305') of the first pair of electrodes and are not connected to the second (307, 307') and third (309, 309') pairs of electrodes, and then measuring the module of the magnetic field (B1) at the level of the magnetometer (311);
controlling the switches (SW1, SW1', SW2, SW2', SW3, SW3') so that the first, second, and third branches are connected in parallel between the electrodes (307, 307') of the second pair of electrodes and are not connected to the first (305, 305') and third (309, 309') pairs of electrodes, and then measuring the module of the magnetic field (B2) at the level of the magnetometer (311); and
controlling the switches (SW1, SW1', SW2, SW2', SW3, SW3') so that the first, second, and third branches are connected in parallel between the electrodes (309, 309') of the third pair of electrodes and are not connected to the first (305, 305') and second (307, 307') pairs of electrodes, and then measuring the module of the magnetic field (B3) at the level of the magnetometer (311).

6. The device (300) of any of claims 2 to 5, wherein the first (L1), second (L2), and third (L3) coils have non-parallel longitudinal axes, for example, substantially orthogonal.

7. The device (300) of any of claims 2 to 6, wherein the magnetometer (311) is a scalar magnetometer.

8. The device (400) of claim 1, comprising a control circuit capable of successively implementing the steps of:
controlling the switches (SW, SW') so that the first coil (L) is not connected to the electrodes (305, 305', 307, 307', 309, 309'), and performing a vector measurement of the ambient magnetic field (B0);
controlling the switches (SW, SW') so that the first coil (L) is connected between the electrodes (305, 305') of the first pair of electrodes and is not connected to the second (307, 307') and third (309, 309') pairs of electrodes, and then performing a vector measurement of the magnetic field (B1) at the level of the magnetometer (411);
controlling the switches (SW, SW') so that the first coil (L) is connected between the electrodes (307, 307') of the third pair of electrodes and is not connected to the first (305, 305') and third (309, 309') pairs of electrodes, and then performing a vector measurement of the magnetic field (B2) at the level of the magnetometer (411); and
controlling the switches (SW, SW') so that the first coil (L) is connected between the electrodes (309, 309') of the third pair of electrodes and is not connected to the first (305, 305') and second (307, 307') pairs of electrodes, and then performing a vector measurement of the magnetic field (B3) at the level of the magnetometer (411).

9. The device (400) of claim 1 or 8, wherein the magnetometer (411) is a vector magnetometer.

10. The device (300; 400) of any of claims 1 to 9, wherein the electrodes (305, 305', 307, 307', 309, 309') have substantially the same surface area (S), and wherein a same distance (D) separates the two electrodes of each of the three pairs of electrodes.
